(19) Europäisches Patentamt
European Patent Office
Office européen des brevets

(11) **EP 4 152 028 A1**

(12) **EUROPÄISCHE PATENTANMELDUNG**

(43) Veröffentlichungstag:
**22.03.2023 Patentblatt 2023/12**

(21) Anmeldenummer: **21197803.6**

(22) Anmeldetag: **20.09.2021**

(51) Internationale Patentklassifikation (IPC):
**G01R 33/3415** (2006.01)   **G01R 33/56** (2006.01)

(52) Gemeinsame Patentklassifikation (CPC):
**G01R 33/5608; G01R 33/3415**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Healthcare GmbH**
**91052 Erlangen (DE)**

(72) Erfinder:
• **Arberet, Simon**
**Princeton 08540 (US)**

• **Biber, Stephan**
**91056 Erlangen (DE)**
• **Kannengießer, Stephan**
**42113 Wuppertal (DE)**
• **Mailhe, Boris**
**Plainsboro, 08536 (US)**
• **Nadar, Mariappan S.**
**Plainsboro 08536 (US)**
• **Ritter, Dieter**
**90762 Fürth (DE)**
• **Schneider, Rainer**
**91054 Erlangen (DE)**

(54) **VERFAHREN UND VORRICHTUNG ZUR UNTERDRÜCKUNG VON STÖRUNGEN BEI DER MAGNETRESONANZBILDGEBUNG**

(57)    Die Erfindung betrifft ein Verfahren zum Betrieb eines Magnetresonanztomographen (1). Der Magnetresonanztomograph (1) weist eine Entstörvorrichtung auf. In dem erfindungsgemäßen Verfahrens wird ein Empfangssignal mit einer Mehrzahl an Empfangsantennen (60) des Magnetresonanztomographen (1) empfangen, unabhängige Quellen des Empfangssignals von der Entstörvorrichtung mit einer Quelltrennung ermittelt, eine einem Magnetresonanzsignal korrespondierende Quelle identifiziert und eine Quelltrennungsfunktion bestimmt, die ausgelegt ist, wenn sie auf das Empfangssignal angewendet wird, ein Ausgangssignal bereitzustellen mit einem verbesserten Signal- zu Störabstand der Magnetresonanzsignalstärke über die Störsignalstärke. Das Verfahren weist den Schritt auf, ein verbessertes Ausgangssignal durch Anwenden der Quelltrennungsfunktion auf das Empfangssignal in der Entstörvorrichtung bereitzustellen. Eine Abbildung wird unter Verwendung des verbesserten Ausgangssignals durch einen Bildrekonstruktionsrechner bereitgestellt und einem Nutzer angezeigt.

FIG 1

EP 4 152 028 A1

**Beschreibung**

Die Erfindung betrifft ein Verfahren zur aktiven Störunterdrückung in einem Magnetresonanztomographen sowie einen Magnetresonanztomographen mit einem Empfänger.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Empfangsantennen, sogenannte Lokalspulen verwendet, die zur Erzielung eines besseren Signal-Rauschabstandes unmittelbar am Untersuchungsobjekt angeordnet werden. Die Empfangsantennen können auch in einer Patientenliege verbaut sein.

Magnetresonanztomographen erfordern in zweierlei Hinsicht eine Hochfrequenzabschirmung. Zum einen werden zur Anregung der Kernspins Hochfrequenzimpulse mit Leistungen im Kilowattbereich erzeugt, die nur teilweise im Patienten absorbiert werden. Radiowellen, die die Patientendurchführung verlassen, werden in den Raum abgestrahlt und müssen daher zur Einhaltung von Emissionsgrenzwerten abgeschirmt werden.
Umgekehrt sind die für die Bildgebung zu empfangenden Magnetresonanzsignale extrem schwach. Um hier ein ausreichendes Signal-zu-Rausch-Verhältnis (SNR) zu erreichen, ist eine Abschirmung externer Störsignal erforderlich.

Deshalb werden im Stand der Technik um einen Magnetresonanztomographen aufwändige Schirmkabinen installiert, um sowohl Emissionen als auch Immissionen zu reduzieren.

Aus der Anmeldung WO 2019/068687 ist ein Verfahren und eine Vorrichtung zur Störunterdrückung in der Magnetresonanzabbildung bekannt.

Es ist daher eine Aufgabe der Erfindung, die Bildgebung in einer Umgebung mit störenden Hochfrequenzsignalen zu verbessern.

Diese Aufgabe wird von einem Verfahren nach Anspruch 1 sowie einem Magnetresonanztomographen nach Anspruch 8 gelöst.

Das Verfahren gemäß der Erfindung ist zum Betrieb eines Magnetresonanztomographen vorgesehen. Der Magnetresonanztomograph weist eine Entstörvorrichtung und eine Mehrzahl an Antennen auf.

In einem Schritt des Verfahrens empfängt der Magnetresonanztomograph ein Empfangssignal mit der Mehrzahl an Antennen. Die Antennen sind vorzugsweise Antennenelemente zum Empfang eines Magnetresonanzsignals, beispielsweise Antennenelemente einer Lokalspule oder einer Körperspule. Die Antennenelemente können auch ein Hilfsantennenelement oder Sensor zum Erfassen von Störungen sein. Die Antennen bzw. Antennenelemente oder Sensoren können auch Signalverarbeitungsmittel aufweisen wie z.B. Rauscharme Vorverstärker (low noise amplifier, LNA) und/oder spektrale Filter.

Das Empfangssignal weist deshalb eine Mehrzahl an Kanälen für jeder der Mehrzahl von Antennenelementen auf. Das Empfangssignal wird an in analoger oder digitaler Form über Kabel oder drahtlos an die Entstörvorrichtung weitergeleitet.

In einem weiteren Schritt ermittelt die Entstörvorrichtung unabhängige Quellen des Empfangssignals. Das Empfangssignal, das bei einer Magnetresonanz-Bilderfassung empfangen wird, weist mindestens zwei Quellen auf, eine Störquelle, üblicherweise in einer Umgebung des Magnetresonanztomographen, und ein Magnetresonanzsignal, das vom Patienten emittiert wird.

Ein Prozessor wendet ein Quelltrennungs-Verfahren auf das Empfangssignal an, um Signalanteile unterschiedlicher Quellen zu trennen. Als Ergebnis werden getrennte Signale zumindest für einen Teil oder alle Quellen bereitgestellt. Die Signale können beispielsweise durch numerische Werte in einem Speicher, einem Prozessor oder in getrennten oder gemultiplexten digitalen Datenströmen repräsentiert sein, die von dem Prozessor ausgegeben werden. Unterschiedliche Verfahren zur Quelltrennung sind in den nachfolgenden Unteransprüchen angegeben.

In einem anderen Schritt des Verfahrens wird eine Quelltrennungsfunktion mit der Entstörvorrichtung ermittelt. Die Quelltrennungsfunktion ist ausgelegt, wenn sie auf das Empfangssignal angewendet wird, ein Ausgangssignal mit einem erhöhten Verhältnis der Signalstärke einer Quelle über eine Signalstärke einer anderen Quelle liefert. Da das Empfangssignal eine Mehrzahl an Kanälen umfasst, kann die Quelltrennungsfunktion die Form einer Matrixfunktion haben. Es ist denkbar, dass die Quelltrennungsfunktion gleichzeitig in dem Schritt des Ermittelns der unabhängigen Quellen mit dem Ermitteln der separaten Quellen ermittelt wird. Es ist ebenso denkbar, dass die getrennten Quellen zum Ermitteln der Quelltrennungsfunktion genutzt werden. Dies hängt davon ab, wie die unabhängigen bzw. getrennten Quellen ermittelt werden, wie nachfolgend in den Unteransprüchen beschrieben ist.

In einem weiteren Schritt des erfindungsgemäßen Verfahrens wird die Quelltrennungsfunktion auf das Empfangssignal angewendet. Wenn das Empfangssignal beispielsweise n = 8 Kanäle aufweist, 4 Kanäle von Antennenspulen von Lokalspulen und 4 Kanäle von Hilfsantennen bzw. Sensoren, und m = 6 unabhängige Quellen wurden identifiziert, beispielsweise 4 Magnetresonanzsignalquellen von den Lokalspulen und 2 Störquellen, kann die Quelltrennungsfunktion eine n x m Matrix sein, d.h. eine 8 x 6 Matrix. Wenn ein Vektor der 8 Kanäle mit der 8 x 6 Matrix multipliziert wird, wird ein Ausgangs-Vektor mit 6 Komponenten bzw. Kanälen bereitgestellt. 4 der 6 Kanäle des Ausgangs-Vektors sind den 4 Magnetresonanzsignalen zugeordnet und 2 den Störquellen. In den den vier Magnetresonanzsignalen zugeordneten Kanälen ist die Signalstärke der Magnetresonanzsignale gegenüber der Signalstärke der Störquellen verbessert, d.h. das Signal-zu Störungs-Verhältnis (SNR) ist höher als in den Ausgangssignalen der Lokalspulen.

Der nächste Schritt des Verfahrens gemäß der Erfindung ist es, die unabhängigen Quellsignale zu identifizieren, die den Magnetresonanzsignalen zugeordnet sind im Gegensatz zu den den Stör- bzw. Rauschquellen zugeordneten Quellsignalen. Die Quelltrennungsfunktion liefert dafür nicht notwendigerweise eine Zuordnung. Ein erstes Auswahl- bzw. Identifikationskriterium beruht dabei auf einer geometrischen Betrachtungsweise: der Winkel zwischen einer vorbestimmten Richtung einer abgeschätzten Mischungsmatrix und dem Teilraum entsprechend der Kanäle/Spulen, die dem Scan zugeordnet sind im Gegensatz zu denen, die nicht dem Scan zugeordnet sind.

Ein zweites Kriterium, die MR-Quellsignale des Körpers beruht auf der Kurtoisis der getrennten unabhängigen Quellsignale, die ein Maß für eine nicht-Gaußverteilung angibt. Die Verteilung, die von einer Gaußverteilung abweicht, ist ein Charakteristikum der Magnetresonanzsignale aus dem Körper im Gegensatz zu Rauschen und Störsignalen.

Nachdem die unabhängigen Quellen identifiziert wurden, können die Signale ohne Störungen wiederhergestellt werden, indem die geschätzte Mischungsmatrix auf die ausgewählten unabhängigen Quellen angewendet wird.

Die Quelltrennungsfunktion und die Identifikation der Quellen können auf einem Prozessor der Entstörvorrichtung implementiert sein. Der Prozessor kann beispielsweise eine Matrixmultiplikation auf die digitalisierten Empfangskanäle mit der zuvor diskutierten Matrix ausführen.

In einem weiteren Schritt des Verfahrens wird eine Abbildung unter Verwendung des verbesserten Ausgangssignals der Quelltrennungsfunktion rekonstruiert. Vorzugsweise werden zur Bildrekonstruktion die Kanäle des Ausgangssignals verwendet, die den Magnetresonanzsignalquellen zugeordnet sind. Die Bildrekonstruktion kann beispielsweise von der Steuerung des Magnetresonanzsystems bereitgestellt werden oder einem dedizierten Bildrekonstruktionsprozessor. Schließlich wird das rekonstruierte Bild einem Nutzer auf einem Display dargestellt.

Das erfindungsgemäße Verfahren verbessert auf vorteilhafte Weise durch die Trennung der Quellen der Eingangssignale die Bildrekonstruktion und somit Artefakte in den resultierenden Abbildungen.

Das erfindungsgemäße Magnetresonanzsystem teilt die Vorteile des erfindungsgemäßen Verfahrens.

In einer Ausführungsform des erfindungsgemäßen Verfahrens wird die Quelltrennung durch eine unabhängige Komponentenanalyse (independent component analysis, ICA) bereitgestellt, vorzugsweise durch einen Fast-ICA-Algorithmus. Als ein Eingangsvektor oder Eingangssignal können der Realteil und der Imaginärteil der k-Raum Abtastwerte für jeden der Empfangskanäle verwendet werden.

In dem Fast-ICA-Algorithmus, wird ein sogenanntes pre-Whitening der Eingangsdaten ausgeführt, sodass eine MischMatrix der Quellen zu dem Empfangssignal eine orthogonale Matrix wird. Die Quelltrennungsfunktion oder EntmischungsMatrix ist in diesem Fall die Transponierte einer orthogonalen Matrix und daher ebenfalls orthogonal und daher als auf orthogonale Matrizen beschränkte einfacher zu bestimmen. Mit anderen Worten, reduziert das pre-Whitening die Anzahl der zu bestimmenden bzw. abzuschätzenden Parameter. Anstatt $n^2$ Parameter abzuschätzen, die Elemente der ursprünglichen Matrix sind, ist nur die neue orthogonale Mischmatrix abzuschätzen, die n(n-1)2 Freiheitsgrade aufweist. Der pre-Whitening-Schritt lässt sich auch auf komplex-wertige Matrizen anwenden, wobei die resultierende Matrix unitär anstelle von orthogonal ist.

Ein ICA-Algorithmus stellt eine robuste und effiziente Methode bereit, um eine Quelltrennungsfunktion zu bestimmen.

In einer Ausführungsform des erfindungsgemäßen Verfahrens ist der ICA-Algorithmus ein Deflation-based FastICA Algorithmus.

Der Deflation-based FatICA Algorithmus ermöglicht die Trennung der Quellen einer nach der anderen, wodurch der Algorithmus auf eine Teilmenge der Quellen wird, und weiterhin die Anpassung der Anzahl der Iterationen.

Ein Pseudo Code des Deflation-based FastICA kann unter https://en.wikipedia.org/wiki/FastICA eingesehen werden. Um die Abweichung von einer Gaußverteilung zu messen, verwendet FastICA auf einer nicht-quadratischen und nicht-linearen Funktion G(x), deren erste Ableitung g(x) und der zweiten Ableitung g'(x).

In einer anderen Ausführungsform des erfindungsgemäßen Verfahrens ist der ICA-Algorithmus ein symmertie-basierter (symmetric-based) FastICA-Algorithmus, was bedeutet, dass die Komponentenvektoren (Spalten der Entmischungsmatrix bzw. Quelltrennungsfunktion) nicht einer nach dem anderen abgeschätzt werden, sondern parallel. Ein Grund dafür ist, dass die deflationäre Methode Abschätzungsfehler im ersten Komponentenvektor in den nachfolgenden Komponentenvektoren durch die Orthogonalisierung akkumuliert werden. Auch ermöglichen die symmetrischen Orthogonalisierungsverfahren eine parallele Berechnung der Komponentenvektoren. Eine symmetrische Orthogonalisierung wird bewerkstelligt, ind3em zunächst die gleichen Iterationsschritte wie bei der deflation-based ICA für jeden Komponentenvektor parallel ausgeführt werden, und dann alle Komponenten durch eine symmetrische Ortholgonalisierungsmethode orthogonalisiert werden, z.B. wie

$$W \leftarrow (WW^T)^{-1/2}W$$

In einer anderen Ausführungsform kann das ICA-Verfahren eines aus komplex-wertige FastICA (complex-valued FastICA), komplexe ICA-EBM (complex ICA-EBM) oder nicht-zirkuläre komplexwertige FastICA (non-circular complex-valued FastICA) sein.

In einer Ausführungsform des erfindungsgemäßen Verfahrens wendet der Schritt der Quelltrennung ein tiefes neuronales Netzwerk an.

In einer Ausführungsform des erfindungsgemäßen Verfahrens wendet die Quelltrennungsfunktion ein tiefes neuronales Netzwerk, dessen Architektur einen ICA-Algorithmus entfaltet. Insbesondere kann die Architektur auf die Anwendung einer komplexwertigen Erweiterung des FastICA algorithmus beruhen. Die g-Funktion des FastICA Algorithmus kann durch ein erstes trainierbares neuronales Netzwerk implementiert sein, und die g'-Funktion, die die Ableitung der Funktion g ist, die in unserem vorgeschlagenen neuronalen Netzwerk unter Verwendung der Kettenregel angewendet auf die Funktion g implementiert werden kann und die Gewichtungsfaktoren mit der Funktion g teilen kann. Wenn beispielsweise g(x)= f(Ax+b) ist, wobei f(x) eine nicht-lineare Aktivierungsfunktion ist, A eine Matrix, die eine voll verknüpfte Schicht und b ein Konstantwert (bias). Dann sind A und b trainierbare Gewichtungsfaktoren des neuronalen Netzwerks und g'(x) = diag(f'(Ax+b))*Ax, wobei A und b Gewichtungsfaktoren wie für g(x) sind.

In einer Ausführungsform wird der Schritt des Identifizierens einer bzw. mehrere unabhängigen Quellen, die einem Magnetresonanzsignal zugeordnet sind, von einem zweiten neuronalen Netzwerk ausgeführt, beispielsweise einem vollständig vernetzten Netzwerk oder einem tiefen neuronalen Netzwerk mit Eingangsmerkmalen wie Kurtoisis und/oder räumlichen Winkel zwischen Spalten der Mischmatrix und einem Teilraum, der Quellen im Inneren des Scanners zugeordnet ist. Ein convolutionales neuronales Netzwerk angewendet auf die Quellkomponenten kann ebenso zur Identifizierung der Quellkomponenten dienen, die Magnetresonanzsignalen zugeordnet sind. Nachdem die Quellkomponenten identifiziert wurden, kann das Magnetresonanzsignal ohne die Störsignale durch einfaches Anwenden der abgeschätzten Mischungsmatrix auf die ausgewählten Quellkomponenten wiederhergestellt werden.

Eine überwachte Dämpfung kann an dieser Stelle mit einem echten Grundsignal (ohne Störungen) angewendet werden, sodass alle Gewichtungsfaktoren des Netzwerks aktualisiert werden.

Innerhalb des ICA Algorithmus wird üblicherweise eine Entmischungsmatrix zur Trennung der Quellen als Quelltrennungsfunktion iterative bestimmt durch Optimisierung einer Kostenfunktion, üblicherweise durch Minimieren der gegenseitigen Information bzw. Korrelation oder Maximieren der nicht-Gauss-Verteilung des Signals.

Das tiefe neuronale Netzwerk trainiert mit den Trainingsdaten, wie nachfolgend beschrieben, kann diese Optimierung auf einem einzelnen Pfad durch das Netzwerk bereitstellen.

In einer denkbaren Ausführungsform des erfindungsgemäßen Verfahrens wird das Empfangssignal an eine Eingangsschicht des tiefen neuronalen Netzwerks angelegt, wobei das tiefe neuronale Netzwerk die Quellen trennt und an einer Ausgangsschicht Signale der getrennten Quellen ausgibt, insbesondere Magnetresonanzsignale.

Ein neuronales Netzwerk kann eine höhere Leistungsfähigkeit als ein iterativer Algorithmus wie ICA bereitstellen. Es kann auch die die Leistungsfähigkeit des ICA-Algorithmus verbessern. Weiterhin kann ein neuronales Netzwerk nicht-lineare Effekte besser berücksichtigen, da die von dem neuronalen Netzwerk bereitgestellte Quelltrennungsfunktion nicht auf eine lineare Matrix beschränkt ist. Insbesondere kann das neuronale Netzwerk anstelle eine Entmischungsmatrix bereitzustellen, Gewichtungsfaktoren für ein weiteres neuronales Netzwerk abschätzen, das zum Entmischen genutzt wird.

In einer Ausführungsform des erfindungsgemäßen Verfahrens weist das Verfahren weiterhin den Schritt des Trainierens des tiefen neuralen Netzwerks mit einem Satz von Trainingsdaten mit bekannten Signalquellen auf. Das Trainieren kann eine Backpropagation zur Anpassung der Gewichtungsfaktoren bzw. Koeffizienten des Netzwerks aufweisen.

Das Trainieren erlaubt auf vorteilhafte Weise die Anpassung an unterschiedliche Konfigurationen und Situationen des Magnetresonanzsystems.

In einer Ausführungsform des erfindungsgemäßen Verfahrens können die Trainingsdaten durch eine Simulation bereitgestellt werden. Störquellen können durch statistische Modelle oder durch Aufnahmen bzw. Samples von Störungen in dem genutzten Frequenzband wie z.B. Spikes, Signale von digitalen Geräten, Mobiltelefonen, drahtgebundener Informationsübertragung oder ähnlichem. Magnetresonanzsignale können durch Bloch-Simulationen gerechnet oder von Bilderfassungen bereitgestellt werden. Mit diesen bekannten Quellsignalen können Empfangssignale berechnet oder simuliert werden unter Verwendung der elektromagnetischen Feldgleichungen für Hochfrequenzsignale oder gemessener Transferfunktionen zwischen Quelle und Antenne.

Die simulierten bzw. berechneten Trainingsdaten stellen einen Satz wohldefinierter Daten bereit, in denen die Quellen genau bekannt sind. Durch die Simulation können die Trainingsdaten leicht an unterschiedliche Umgebungen angepasst werden, selbst wenn diese Umgebungen noch nicht zum Testen und Trainieren bekannt sind.

In einer Ausführungsform des erfindungsgemäßen Verfahrens liefert eine erste vorzugsweise echte Teilmenge bzw. Teil der Antennen ein Signal in dem ein Anteil des Magnetresonanzsignals höher als ein Pegel des bzw. eines Störsignals ist und eine zweite vorzugsweise echte Teilmenge der Antennen ein Signal, in dem ein Pegel des Störsignals höher als ein Pegel des Magnetresonanzsignals ist. Dies kann beispielsweise erreicht werden, indem die zweite Teilmenge der Antennen außerhalb des Patiententunnels und/oder näher an einer Störquelle angeordnet ist als eine Lokalspule der ersten Teilmenge, die unmittelbar an der Quelle des Magnetresonanzsignals ist.

Die unterschiedlichen Pegel von Störung und Magnetresonanzsignal erleichtern das Identifizieren der getrennten Quellen als entweder zu der Störquelle oder der Magnetresonanzquelle gehörig. Dies kann beispielsweise in dem Schritt des Identifizierens der unabhängigen Quellen entsprechend dem bzw. den Magnetresonanzsignalen als ein geometrisches Kriterium zur Auswahl der Quellen genutzt werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Fig. 1    zeigt ein schematisches Diagramm eines Magnetresonanztomographen zur Ausführung des erfindungsgemäßen Verfahrens;

Fig. 2    zeigt ein schematisches Diagramm eines Empfängers des erfindungsgemäßen Magnetresonanztomographen;

Fig. 3    zeigt ein schematisches Ablaufdiagramm des erfindungsgemäßen Verfahrens.

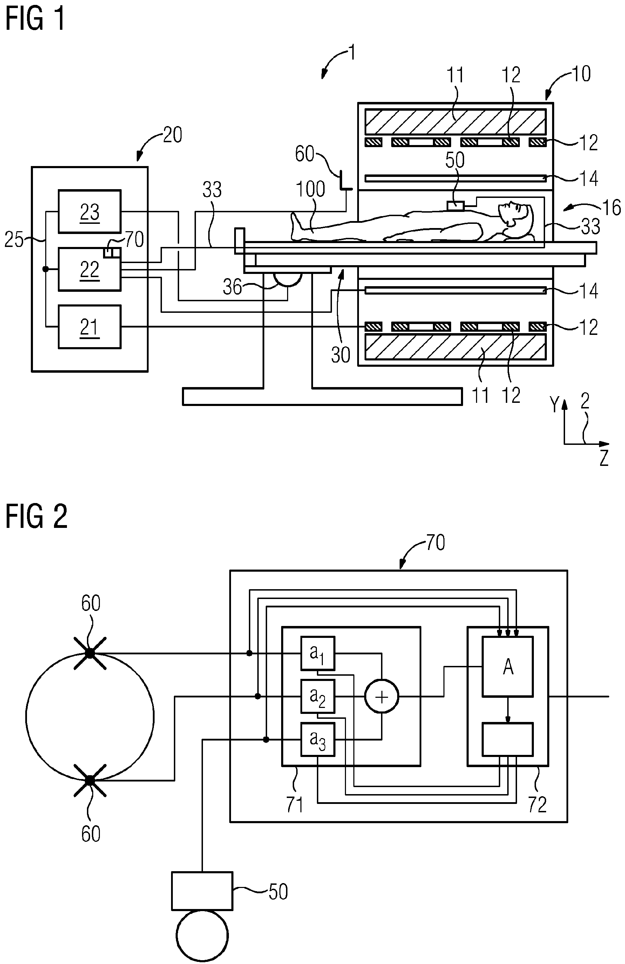

Fig. 1 zeigt eine schematische Darstellung einer Ausführungsform eines Magnetresonanztomographen 1 mit einer erfindungsgemäßen Lokalspule 50.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt. Eine Patientenliege 30 ist in dem Patiententunnel 16 von der Verfahreinheit 36 bewegbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungspulse können über die Körperspule 14 oder auch über eine lokale Sendeantenne in den Patienten 100 abgestrahlt werden. Eine Steuerung 23 kommuniziert über einen Signalbus 25 mit der Gradientensteuerung 21 und der Hochfrequenzeinheit 22.

Auf dem Patienten 100 ist als eine erste Empfangsspule eine Lokalspule 50 angeordnet, die über eine Anschlussleitung 33 mit der Hochfrequenzeinheit 22 und deren Empfänger verbunden ist. Denkbar ist es aber auch, dass die Körperspule 14 eine erste Empfangsantenne im Sinne der Erfindung ist.

An einem Rand der Öffnung des Patiententunnels 16 sind vier zweite Empfangsantennen 60 angeordnet, die an den Ecken eines Quadrates angeordnet sind, das der kreisförmigen Öffnung einbeschrieben ist, sodass die Ecken auf dem Rand der Öffnung zu liegen kommen. Die vier zweiten Empfangsantennen 60 stehen in Signalverbindung mit dem Empfänger 70 der Hochfrequenzeinheit 22. Aufgrund der Mehrzahl der zweiten Empfangsantennen 60 ist es dabei denkbar, dass diese nicht alle eine Rundum-Empfangscharakteristik aufweisen, sondern beispielsweise Dipole sind und sich durch die unterschiedliche Ausrichtung zu einer Rundum-Charakteristik ergänzen. Es wäre aber beispielsweise auch denkbar, als einzige zweite Antenne mit Rundum-Charakteristik einen Kreuzdipol vorzusehen.

Es ist auch denkbar, dass alternativ oder zusätzlich eine oder mehrere zweite Empfangsantenne 60 in einem größeren Abstand von dem Patiententunnel 16 angeordnet sind, beispielsweise in einem Fernfeld von Hochfrequenzsignalen, die aus dem Patiententunnel 16 emittiert werden.

Auf vorteilhafte Weise sollen die zweiten Antennen 60 einen höheren Pegel des Störsignals oder Rauschens in Relation zu dem Magnetresonanzsignal bereitstellen im Vergleich zu den Lokalspulen 50 oder ersten Antennen, die in dem Patiententunnel 16 unmittelbar an dem Patienten 100 angeordnet sind. Dieser Fakt kann im Rahmen des erfindungsgemäßen Verfahrens genutzt werden, um zwischen Störquellen und Magnetresonanzquellen zu unterscheiden, d.h. insbesondere zum Identifizieren der Magnetresonanzquellen.

Die Empfangssignale sowohl von ersten Antennen bzw. Lokalspulen 50 als auch zweiten Antennen 60 werden von den ersten Antennen und zweiten Antennen 60 zu dem Empfänger 70 übertragen, in dem vorzugsweise das erfindungsgemäße Verfahren ausgeführt wird. Die Empfangssignale sind vorzugsweise vorverarbeitet, was Verstärken, Filtern, Digitalisieren und/oder Frequenzumsetzung oder beliebige Kombinationen daraus umfassen kann.

Beispielsweise kann das Empfangssignal bzw. die Empfangssignale in der Lokalspule 50 oder zweiten Antenne 60 verstärkt und über Kabel an den Empfänger 70 des Magnetresonanztomographen 1 übertragen werden. Die Signale werden gefiltert, üblicher Weise in der Frequenz umgesetzt und digitalisiert, um Amplituden- Frequenz- und Phaseninformation bereitzustellen. Das bzw. die Empfangssignale können durch einen Strom (stream) oder ein Array von komplexen Zahlen der Entstörvorrichtung präsentiert werden.

Die Entstörvorrichtung kann die Entstörsteuerung 73 oder ein anderer Prozessor sein, der zumindest einige oder alle Schritte des nachfolgend beschriebenen erfindungsgemäßen Verfahrens ausführt.

Fig. 2 zeigt ein schematisches Diagramm von funktionalen Einheiten einer möglichen Ausführungsform des Empfängers 70.

Die Summationseinrichtung 71 gewichtet die von der bzw. den ersten Empfangsantennen bzw. Lokalspule 50 und von den zweiten Empfangsantennen 60 eingehenden Signale mit Parametern, die auch komplex sein können, um eine Phasenverschiebung anzugeben. In einem analogen Empfänger 70 kann dies durch einen einstellbaren Verstärker in Verbindung mit einem einstellbaren Phasenschieber erfolgen. Der Realteil des Parameters entspricht dann dem Verstärkungsfaktor und der Imaginärteil der Phasenverschiebung. Anschließend werden in einer bevorzugten Ausführungsform die gewichteten Signale summiert, es sind aber auch andere nichtlineare Signaloperationen zur Kombination der Einzelsignale denkbar.

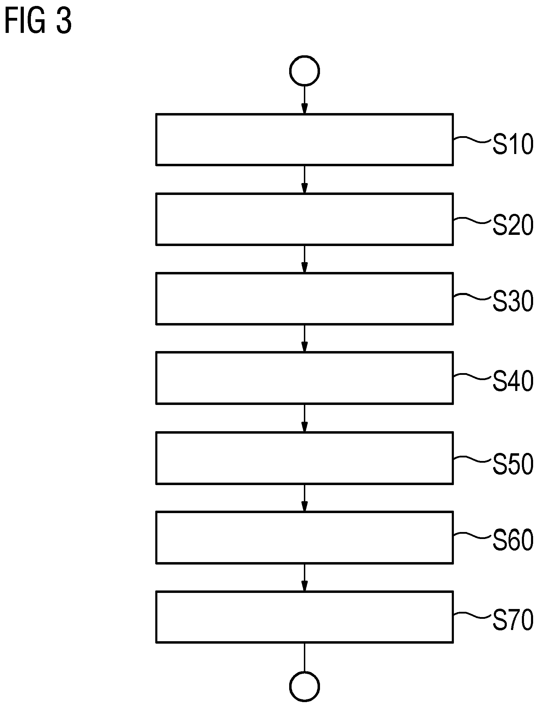

Eine Entstörsteuerung 72 ermittelt vorzugsweise die besten Gewichtungsfaktoren durch Ausführen des erfindungsgemäßen Verfahrens, das näher in Verbindung mit Fig. 3 nachfolgend erläutert wird. Das Verfahren kann aber auch teilweise oder vollständig von einem dedizierten Prozessor oder einer Hardware, beispielsweise der Steuerung 23 ausgeführt werden.

Grundsätzlich kann der Empfänger 70 sowohl in analoger Signalverarbeitungstechnik ausgeführt sein, sodass z.B. Verstärkungsregelung und Phasenverschiebung durch einen Parameter gesteuert und dann analog umgesetzt werden, oder auch als digitaler Empfänger, der entweder bereits digitalisierte Signale von der ersten Empfangsantenne und/ oder der zweiten Empfangsantenne 60 erhält oder diese bereits am Signaleingang mittels eines A/D-Wandlers digitalisiert.

Der Empfänger 70 leitet das kombinierte Signal, in dem das Störsignal weitestgehend unterdrückt ist, zur Bildgebung an die Steuerung 23 des Magnetresonanztomographen weiter.

In Fig. 3, ist ein schematisches Ablaufdiagramm des erfindungsgemäßen Verfahrens dargestellt.

In einem Schritt S10 empfängt der Magnetresonanztomograph 1 ein Empfangssignal mit einer Mehrzahl an Antennen. Das Empfangssignal ist vorzugsweise ein Signal mit einer Mehrzahl an Kanälen, für jede der Antennen einzeln oder für kombinierte Signale der Antennen. Das Empfangssignal kann vorverarbeitet sein, beispielsweise durch einen rauscharmen Vorverstärker (low nois amplifier, LNA) und/oder einen Bandpassfilter. Das Signal kann auch auf eine andere Frequenz umgesetzt werden, beispielsweise zum Multiplexen von Signalen. Es ist auch denkbar, dass das Empfangssignal in der Antenne oder dem Empfänger 70 des Magnetresonanztomographen 1 digitalisiert wird.

In einem anderen Schritt S20 werden unabhängige Quellen des Empfangssignals ermittelt. Diese unabhängigen Quellen sind üblicherweise nicht identisch mit den einzelnen Signalen jeder Antenne. Es können verschiedene Störquellen vorhanden sein, beispielsweise elektronische Geräte, die um den Magnetresonanztomographen 1 verteilt sind, oder andere weiter entfernte Quellen wie Rundfunksender, elektrische Züge oder Antriebe. Die Antennen empfangen üblicherweise eine Mischung elektromagnetischer Wellen von jeder dieser Quellen, jede Antenne mit einer unterschiedlichen Gewichtung jeder Störquelle. Vorzugsweise ist die Mischung von Störsignal und Magnetresonanzsignal unterschiedlich für jede Antenne. Beispielsweise wird eine Lokalspule 50 in unmittelbarer Nähe zu dem Patienten 100 in dem Patiententunnel 16 ein stärkeres Magnetresonanzsignal empfangen, während Störsignale von außerhalb des Patiententunnels 16 durch den Patiententunnel 16 gedämpft werden. Auf der anderen Seite sind die zweiten Empfangsantennen 60 vorzugsweise außerhalb des Patiententunnel 60 angeordnet, sodass die Störquellen eine größere Amplitude in den Kanälen des Empfangssignals der zweiten Antennen bzw. Empfangsantennen 60 verursachen.

In dem Schritt S20 werden die unterschiedlichen unabhängigen Quellen in dem Signalmix des Empfangssignals von der Entstörvorrichtung ermittelt. Die Störquellen haben unterschiedliche Eigenschaften als das Magnetresonanzsignal. Die Magnetresonanzsignale haben beispielsweise eine spezielle zeitliche und Frequenz-Verteilung, während Störsignalquellen üblicherweise keine Korrelation untereinander aufweisen oder sogar jeweils individuell statistisch verteilte Eigenschaften.

Das Empfangssignal kann als Vektor $\vec{x}$ dargestellt werden, der sich aus den Signalen der Quellen, als Vektor $\vec{s}$ dargestellt, durch Multiplikation von $\vec{s}$ mit der Übertragungsmatrix A. Die Übertragungsmatrix A kann aus der Geometrie der Verteilung der Quellen und Antennen im Raum abgeleitet werden. Die Koeffizienten repräsentieren die Dämpfung und Phasenverschiebung der Signale auf dem Weg zwischen Signalquelle und Antenne. Im leeren Raum und bei großem Abstand ist die Dämpfung proportional zu dem Kehrwert des Abstandes und kann anhand der Maxwellschen Gleichungen berechnet werden. Die Phasenverschiebung ist proportional zum Abstand geteilt durch die Lichtgeschwindigkeit. Zusätzlich kann eine Dämpfung und deine Phasenverschiebung auf der Verbindung zwischen Antenne und Empfänger auftreten.

$$\vec{x} = A\vec{s}$$

Die Quelltrennung soll den Vektor $\vec{s}$ aus dem Empfangssignal $\vec{x}$ ermitteln.

Eine Methode zur Quelltrennung wird durch die unabhängige Komponenten Analyse (independent component analysis, ICA) bereitgestellt. Eine spezielle und effizientere Version der ICA ist die sogenannte FastICA-Methode, die vorzugsweise für die Quelltrennung angewendet wird.

Um die Matrix A oder die inverse Matrix $A^{-1}$ zu bestimmen, wird ein Array oder Matrix von Empfangssignalen verwendet $X := (x_{ij}) \in R^{NxM}$ mit N als Anzahl der unabhängigen Quellen M der Anzahl der Abtastwerte bzw. Samples der Empfangssignale.

In einem als "pre-Whitening" bezeichneten Schritt, wird die Matrix X zentriert, sodass jede Zeile von X entsprechend den Signalen einer Quelle einen Erwartungswert 0 annimmt. Anschließend wird die Matrix einem Whitening unterworfen, was bedeutet, dass eine Lineartransformation L angewendet wird, sodass die Komponenten von L(X) unkorreliert und eine Varianz gleich 1 aufweisen. Dies kann durch eine Eigenwert-Zerlegung der Covarianz-Matrix der zentrierten Daten erreicht werden,

Die Matrix nach dem "Whitening" ist definiert durch:

$$X \leftarrow D^{-\frac{1}{2}} E^T X$$

Wobei E die Matrix der Eigenvektoren und D die Diagonalmatrix der Eigenwerte.

Mit der "pre-whitened" Matrix X als Eingangswert, kann ein Gewichtungsvektor $w \in R^N$ unter Nutzung unterschiedlicher Versionen des FastICA-Algorithmus ermittelt werden, wobei der FastICA-Algorithm ein Maß für die nicht-Gauss-Verteilung der Projektion $w^T X$ maximiert. Um die das Maß für die nicht-Gauss-Verteilung zu bestimmen, verwendet FastICA eine nichtquadratische nichtlineare Funktion f(u) bzw. G(u), deren erste Ableitung g(u) und die zweite Ableitung g'(u).

Mit C als die Anzahl der gewünschten Komponenten, X der "whitened" Matrix, kann eine Entmischungsmatrix $W \in R^{NxC}$ ermittelt werden, die X auf unabhängige Komponenten projiziert und somit eine Quelltrennungsfunktion darstellt, und eine Matrix $S \in R^{CxM}$, die unabhängige Komponenten des Empfangssignals für M Quellen und eine Abtastlänge C bereitstellt, mit den folgenden in einer symbolischen Programmiersprache angegebenen Schritten:

Für p von 1 bis C

w$_p$ ← Zufallsvektor der Länge N
solange w$_p$ sich ändert

$$w_P \leftarrow \frac{1}{M} X g\left(w_p{}^T X\right)^{\top} - \frac{1}{M} X g'\left(w_p{}^T X\right) 1_M w_p$$

$$w_P \leftarrow w_P - \sum_{I=1}^{p-1} \left(w_p{}^T w_j\right) w_j$$

$$w_P \leftarrow \frac{w_P}{\|w_P\|}$$

Ausgabe $W <- [w_1, ... w_c]$
Ausgabe $S \leftarrow W^T X$

Das Ergebnis des FastICA Algorithmus sind die Entmischungsmatrix $W$ und die getrennten Quellen $S$. Der FastICA Algorithmus ermittelt nicht, welche der getrennten Quellen zu einer Störquelle gehört und welche der getrennten Quellen zu einem Magnetresonanzsignal.

Andere Ausführungsformen der ICA Quelltrennung die verwendet werden können, sind die komplexwertige FastICA, die von M. Novey und T. Adali in "On extending the complex FastICA algorithm to noncircular sources, " IEEE Trans. Signal Processing, vol. 56, no. 5, pp. 2148-2154, May 2008, veröffentlicht wurden. Dieser Algorithmus geht nicht von zirkularen Quellen aus.

Auch der komplexwertige ICA-EBM-Algorithmus, publiziert von X.-L. Li und T. Adali, "Complex independent component analysis by entropy bound minimization," IEEE Trans. Circuits and Systems I, vol. 57, no. 7, pp. 1417-1430, July 2010 kann zum Ermitteln der Quelltrennungsfunktion genutzt werden.

In einer Ausführungsform des erfindungsgemäßen Verfahrens wendet der Schritt S20 zum Bestimmen der Quelltrennungsfunktion ein tiefes neuronales Netzwerk an. Beispielsweise können die nichtlineare Funktion g und ihre Ableitung g' durch ein neuronales Netzwerk ersetzt werden. Das neuronale Netzwerk kann beispielsweise mit virtuellen Daten, die synthetisch mittels Feldgleichungen berechnet werden, oder mittels Testdaten, die in einer Testumgebung mit bekannten Quellen gewonnen werden, trainiert werden. Es ist auch denkbar, dass die Daten in einem System gesammelt werden, in dem das zuvor beschriebenen FastICA genutzt wird. Das Netzwerk wird auf eine schnelle Konvergenz des ICA-Algorithmus hin trainiert.

In Fast-ICA Algorithmen sind die g und g' Funktionen elementindividuelle Funktionen, d.h. eindimensionale Funktionen, die auf alle Koeffizienten angewendet werden. Eine mögliche Implementierung des neuralen Netzwerks für die g-Funktion ist ein eindimensionales (1D) Multi-Layer Netzwerk, zusammengesetzt aus mehreren voll vernetzten Schichten mit ReLU-Aktivierungen. Eine andere Möglichkeit ist ein 1D konvolutionales Netzwerk (1D CNN).

In einer anderen denkbaren Ausführungsform kann die gesamte Quelltrennungsfunktion als neuronales Netzwerk implementiert sein, das die getrennten Quellen bereitstellt, wenn es mit dem Empfangssignal gefüttert wird. Das neuronale Netzwerk kann mit simulierten Daten trainiert sein, die durch Feldberechnung mit virtuellen Magnetresonanzsignalen und Störquellen gewonnen werden. Es ist auch denkbar, dass die Trainingsdaten in einer Testumgebung oder während der Installation des Magnetresonanztomographen 1 mit der Entstörvorrichtung gewonnen werden.

In einem weiteren Schritt S30 wird eine unabhängige Quelle identifiziert, die mit einem Magnetresonanzsignal korrespondiert. Die Quelltrennungsfunktion trennt Signale unterschiedlicher Quellen, bietet aber zunächst keine Information, welche der Quellen zu einem Magnetresonanzsignal gehört. Die Quellen müssen anhand anderer Eigenschaften identifiziert werden. Dies könnte beispielsweise die Stärke des Signals sein. Wie zuvor beschrieben, können die Antennen so im Raum verteilt sein, dass das Empfangssignal der ersten Antennen einen höheren Signalanteil des Magnetresonanzsignals im Vergleich zum Störsignal aufweist. Dies kann insbesondere für das Signal der ersten Antennen der Fall sein. Entsprechend sind in der Mischungsmatrix die Koeffizienten für die Magnetresonanzsignale in den Matrixelementen am größten, die den Empfangssignalen der ersten Antennen zugeordnet sind, beispielsweise den Lokalspulen 50 in unmittelbarer Nähe des Patienten 100.

Die Quellen können auch anhand anderer Eigenschaften identifiziert werden. Die Magnetresonanzsignale haben eine spezifische Frequenzverteilung und einen zeitlichen Verlauf gemäß der Bilderfassung. Der zeitliche Verlauf kann beispielsweise durch Autokorrelation der Quellensignale untereinander ermittelt werden. Während die Magnetresonanzsignale eine hohe Korrelation untereinander aufweisen, sind die unterschiedlichen Störquellen üblicherweise unabhängig voneinander und statistisch verteilt. Es ist auch denkbar, diese verschiedenen Ansätze in Schritt S30 zu kombinieren, um die Magnetresonanzsignalquellen zu identifizieren.

In einer Ausführungsform des erfindungsgemäßen Verfahrens kann die Auswahl des Magnetresonanzsignals durch ein neuronales Netz bereitgestellt werden, wobei die getrennten Quellen einer Eingangsschicht zugeführt werden und die ausgewählten Magnetresonanzsignale an einer Ausgangsschicht bereitgestellt werden. Das neuronale Netzwerk kann in einem deep-learning-Prozess mit daten aus einer simulierten oder realen Testumgebung trainiert werden.

In einem weiteren Schritt S40 des erfindungsgemäßen Verfahrens wird eine Quelltrennungsfunktion von der Entstörvorrichtung ermittelt. Die Quelltrennungsfunktion ist ausgelegt, wenn sie auf das Empfangssignal angewendet wird, ein Ausgangssignal mit einem verbesserten Signalabstand einer Magnetresonanz-Signalstärke im Vergleich zu einer Störsignalstärke bereitzustellen. Dies kann beispielsweise durch eine Kombination der Ergebnisse der Schritte S20 und S30 bereitgestellt werden. Während S20 eine Entmischungsmatrix bereitstellt, identifiziert Schritt S30 die Magnetresonanzsignale bzw. deren Quellen unter den unabhängigen Quellen. Indem die Magnetresonanzsignale entsprechend aus den getrennten Quellsignalen ausgewählt werden, stellt die Entstörvorrichtung Magnetresonanzsignale bereit, in denen die Störsignale unterdrückt sind, indem die Energie zu den Quellsignalen übertragen wird, die den Störquellen zugeordnet sind.

Diese Quelltrennungsfunktion wird dann in Schritt S50 von der Entstörvorrichtung auf das Empfangssignal angewendet, um einen Strom an Magnetresonanzsignalen mit einem reduzierten Störsignalanteil und einem verbesserten SNR bereitzustellen.

In einem weiteren Schritt S60 wird ein Bild unter Verwendung des verbesserten Ausgangssignals von einem Bildrekonstruktionsprozessor rekonstruiert, was beispielsweise die Steuerung 23 des Magnetresonanztomographen 1 sein kann oder ein dedizierter Bildrekonstruktionsrechner.

In einem weiteren Schritt S70 wird das rekonstruierte Bild an einen Nutzer ausgegeben.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren zum Betrieb eines Magnetresonanztomographen (1), wobei der Magnetresonanztomograph (1) eine Entstörvorrichtung aufweist, wobei das Verfahren die Schritte aufweist:

    Empfangen (S10) eines Empfangssignals mit einer Mehrzahl an Antennen des Magnetresonanztomographen (1);
    Ermitteln unabhängiger Quellen (S20) des Empfangssignals mittels einer Quelltrennung der Entstörvorrichtung;
    Identifizieren (S30) einer unabhängigen Quelle, die einem Magnetresonanzsignal zugeordnet ist;
    Ermitteln einer Quelltrennungsfunktion (S40) mit der Entstörvorrichtung, wobei die Quelltrennungsfunktion ausgelegt ist, wenn sie auf das Empfangssignal angewendet wird, ein Ausgangssignal bereitzustellen, das ein verbessertes Signal-zu-Rausch-Verhältnis aufweist;
    Bereitstellen eines verbesserten Ausgangssignals durch Anwenden (S50) der Quelltrennungsfunktion auf das Empfangssignal in der Entstörvorrichtung;
    Rekonstruieren einer Abbildung (S60) unter Verwendung des verbesserten Ausgangssignals durch einen Bildrekonstruktionsrechner;
    Anzeigen (S70) der Abbildung für einen Anwender.

2. Verfahren nach Anspruch 1, wobei die Quelltrennung durch eine unabhängige Komponentenanalyse bereitgestellt wird.

3. Verfahren nach Anspruch 2, wobei der Algorithmus zur unabhängigen Komponentenanalyse ein deflation-based FastICA Algorithmus ist.

4. Verfahren nach Anspruch 2, wobei der Algorithmus zur unabhängigen Komponentenanalyse ein symmetric-based FastICA Algorithmus ist.

5. Verfahren nach einem der Ansprüche 1 bis 4, wobei der Schritt des Identifizierens (S30) von einem Winkel zwischen den Quellen abhängig ist, die von der Quelltrennungsfunktion ermittelt wurden.

6. Verfahren nach einem der Ansprüche 1 bis 4, wobei der Schritt des Identifizierens (S30) von einer statistischen Eigenschaft des Signals abhängig ist.

7. Verfahren nach Anspruch 5, wobei eine erste Teilmenge der Antennen ein Signal bereitstellt, in dem ein Pegel des Magnetresonanzsignals höher ist als ein Pegel des Störsignals und eine zweite Teilmenge der Antennen ein Signal bereitstellt, in dem ein Pegel des Störsignals höher ist als ein Pegel des Magnetresonanzsignals.

8. Magnetresonanztomograph (1), wobei der Magnetresonanztomograph (1) eine Entstörvorrichtung aufweist, wobei der Magnetresonanztomograph (1) ausgelegt ist, die Schritte nach einem der Ansprüche 1 bis 7 auszuführen.

9. Computerprogrammprodukt, welches direkt in einen Prozessor einer programmierbaren Steuerung (23) ladbar ist, mit Programmcode-Mitteln, um alle Schritte eines Verfahrens nach einem der Ansprüche 1 bis 7 auszuführen, wenn das Programmprodukt auf der Steuerung (23) ausgeführt wird.

10. Computerlesbares Speichermedium mit darauf gespeicherten elektronisch lesbaren Steuerinformationen, welche derart ausgestaltet sind, dass sie bei Verwendung des Speichermediums in einer Steuerung (23) eines Magnetresonanztomographen (1) nach Anspruch 8 das Verfahren nach einem der Ansprüche 1 bis 7 durchführen.

FIG 1

FIG 2

FIG 3

Europäisches
Patentamt

European
Patent Office

Office européen
des brevets

**EUROPÄISCHER RECHERCHENBERICHT**

**Nummer der Anmeldung**

**EP 21 19 7803**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | CN 113 180 636 A (HANGZHOU WEIYING MEDICAL TECH CO LTD) 30. Juli 2021 (2021-07-30) | 1-10 | INV.<br>G01R33/3415<br>G01R33/56 |
| Y | * Abbildungen 1,2,3,5,6 *<br>* Absatz [0046] - Absatz [0089] *<br>----- | 3,4 | |
| X | US 2018/143272 A1 (LIU YONG [NL])<br>24. Mai 2018 (2018-05-24) | 1-10 | |
| Y | * Abbildung 1 *<br>* Absatz [0048] - Absatz [0080] *<br>----- | 3,4 | |
| Y | MIETTINEN JARI ET AL: "fICA: FastICA Algorithms and Their Improved Variants",<br>THE R JOURNAL,<br>Bd. 10, Nr. 2, 1. Januar 2018 (2018-01-01)<br>, Seiten 148-158, XP055894125,<br>DOI: 10.32614/RJ-2018-046<br>Gefunden im Internet:<br>URL:https://journal.r-project.org/archive/2018/RJ-2018-046/RJ-2018-046.pdf><br>* Kurzzusammenfassung *<br>----- | 3,4 | |

**RECHERCHIERTE SACHGEBIETE (IPC)**

G01R

Der vorliegende Recherchenbericht wurde für alle Patentansprüche erstellt

| Recherchenort | Abschlußdatum der Recherche | Prüfer |
|---|---|---|
| **München** | **25. Februar 2022** | **Durst, Markus** |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument
..............................................................
& : Mitglied der gleichen Patentfamilie, übereinstimmendes
Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

**EP 21 19 7803**

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

**25-02-2022**

| Im Recherchenbericht angeführtes Patentdokument | Datum der Veröffentlichung | Mitglied(er) der Patentfamilie | Datum der Veröffentlichung |
|---|---|---|---|
| CN 113180636 A | 30-07-2021 | KEINE | |
| US 2018143272 A1 | 24-05-2018 | BR 112017023027 A2 | 03-07-2018 |
| | | CN 107533117 A | 02-01-2018 |
| | | EP 3289372 A1 | 07-03-2018 |
| | | JP 6684826 B2 | 22-04-2020 |
| | | JP 2018519861 A | 26-07-2018 |
| | | RU 2017135047 A | 05-04-2019 |
| | | US 2018143272 A1 | 24-05-2018 |
| | | WO 2016173861 A1 | 03-11-2016 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2019068687 A

**In der Beschreibung aufgeführte Nicht-Patentliteratur**

- **M. NOVEY ; T. ADALI.** On extending the complex FastICA algorithm to noncircular sources. *IEEE Trans. Signal Processing,* Mai 2008, vol. 56 (5), 2148-2154

- **X.-L. LI ; T. ADALI.** Complex independent component analysis by entropy bound minimization. *IEEE Trans. Circuits and Systems I,* Juli 2010, vol. 57 (7), 1417-1430